# EUROPÄISCHE PATENTANMELDUNG

(11) **EP 3 502 974 A1**
(43) Veröffentlichungstag der Anmeldung: **26.06.2019**
(21) Anmeldenummer: 17208770.2
(22) Anmeldetag: 20.12.2017
(51) Int. Cl.: G06N 3/063, G06F 17/50

(54) **VERFAHREN ZUR REALISIERUNG EINES NEURONALEN NETZES**

(71) Anmelder: Siemens Aktiengesellschaft, 80333 München (DE)
(72) Erfinder: Hinterstoisser, Thomas, 2102 Bisamberg (AT); Matschnig, Martin, 3430 Tulln (AT); Taucher, Herbert, 2340 Mödling (AT)
(74) Vertreter: Maier, Daniel Oliver

(57) **Zusammenfassung**

Die Erfindung betrifft ein Verfahren zur Realisierung eines künstlichen, neuronalen Netzes mittels einer elektronischen, integrierten Schaltung (SE) wie z.B. mittels eines FPGAs, wobei das künstliche, neuronale Netz aus künstlichen Neuronen aufgebaut wird. Diese werden in unterschiedliche Schichten (ES, VS, AS) gruppiert und miteinander vernetzt. Für jedes Neuron des künstlichen, neuronalen Netzes wird eine funktionale Beschreibung unter Berücksichtigung einer vorgebbaren Startgewichtung erstellt (101). Auf Basis der jeweiligen funktionalen Beschreibung mit der jeweils zugehörigen, vorgegebenen Startgewichtung für das jeweilige Neuron wird eine Synthese durchgeführt (102). Als Syntheseergebnis wird eine Netzliste ermittelt (103), in welcher für jedes Neuron zumindest ein Basiselement (BE1, BE2) sowie eine zum Basiselement (BE1, BE2) gehörende Startkonfiguration hinterlegt werden. Dabei wird ein Basiselement (BE1, BE2) von einer sogenannten Lookup-Table-Einheit bzw. LUT-Einheit (LUT1, LUT2) und einer zugeordneten, dynamischen Konfigurationszelle (KON1, KON2) gebildet, in welcher eine jeweils aktuelle Konfiguration für die LUT-Einheit (LUT1, LUT2) bzw. für das Basiselement (BE1, BE2) abgelegt ist. Die Netzliste wird dann als Startkonfiguration des künstlichen, neuronalen Netzes in der elektronischen, integrierten Schaltung (SE) implementiert (104).

## Beschreibung

### Technisches Gebiet

Die gegenständliche Erfindung betrifft allgemein das Gebiet der künstlichen, neuronalen Netze. Insbesondere bezieht sich die vorliegende Erfindung auf ein Verfahren zur Realisierung eines künstlichen, neuronalen Netzes mittels einer elektronischen, integrierten Schaltung, insbesondere mittels eines sogenannten Field Programmable Gate Arrays oder FPGAs. Dabei ist das künstliche, neuronale Netz aus künstlichen Neuronen aufgebaut, welche in unterschiedliche Schichten gruppiert und miteinander vernetzt werden.

### Stand der Technik

Heutzutage werden künstliche, neuronale Netz häufig bei Anwendungen eingesetzt, bei welchen kein oder nur geringes, explizites systematisches Wissen über das zu lösende Problem vorliegt bzw. für welche es schwierig ist, einen passenden, durch einen Rechner ausführbaren Algorithmus herzuleiten. Derartige Anwendungen liegen z.B. in Bereichen wie der Text-, Bild- und Mustererkennung, der schnelle Entscheidungsfindungen und/oder der Klassifikationsaufgaben.

Ein künstliches, neuronales Netz stellt im Prinzip eine Nachbildung von biologischen Nervensystemen mit ihrer assoziativen Arbeitsweise dar. Die herausragende Eigenschaft des künstlichen, neuronales Netzes besteht insbesondere in der Lernfähigkeit - d.h. gestellte Probleme wie z.B. Text-, Bild- oder Mustererkennungen, rasche Entscheidungsfindungen, etc. werden auf Basis von trainiertem Wissen gelöst. Ein künstliches, neuronales Netz besteht aus einer Vielzahl von künstlichen Neuronen, welche beispielsweise menschlichen Gehirnzellen nachempfunden sind. Die Neuronen werden im neuronalen Netz in unterschiedlichen Schichten gruppiert und sind durch einen hohen Vernetzungsgrad gekennzeichnet. Als Schichten sind beispielsweise zumindest eine Eingangsschicht zur Aufnahme von Rohdaten, und eine Ausgangsschicht, von welcher der Abschluss bzw. das vom neuronalen Netz ermittelte Ergebnis bereitgestellt wird, vorgesehen. Dazwischen können eine oder mehrere "versteckte" Schichten vorgesehen sein, von welchen Zwischenergebnisse ermittelt und bereitgestellt werden. Ein beispielhaftes neuronales Netz sowie eine beispielhafte Anwendungen aus dem Bereich der Muster- bzw. Spracherkennung sind z.B. aus der Schrift EP 0 595 889 B1 bekannt.

Um für eine vorgegebene Aufgabe (z.B. Text-, Bild- oder Mustererkennung, Entscheidungsfindung oder Klassifizierungsaufgabe, etc.) einsetzbar zu sein, muss das neuronale Netz während einer Trainingsphase trainiert werden. Während dieser Trainingsphase wird das neuronale Netz anhand z.B. vorgegebener Trainingsdaten und/oder -mustern trainiert, eine im Bezug auf die Aufgabe richtige Antwort zu liefern. Dabei werden ausgehend von z.B. vorgebbaren oder zufällig gewählten Werten für eine Startgewichtung bzw. für Startgewichtungsfaktoren, welche den Neuronen zugeschrieben werden, Gewichtung bzw. Gewichtungsfaktor und gegebenenfalls ein Biaswert für das jeweilige Neuron je Trainingszyklus modifiziert. Die im jeweiligen Trainingszyklus erhaltenen Ergebnisse des neuronalen Netzes werden dann z.B. mit Referenzdaten/-muster verglichen, bis eine gewünschte Ergebnisqualität erzielt worden ist.

Aufgrund der parallelen Verarbeitungsstruktur ist eine reine Software-Realisierung von neuronalen Netzen, welche durch einen CPU oder GPU ausgeführt wird, oft wenig praktikabel, insbesondere da die Trainingsphase für das neuronale Netz meist relativ rechenintensiv ist. Nicht selten ist dafür eine hohe Rechenleistung erforderlich, wobei die Verarbeitung meist eher langsam abläuft. Bei einer Realisierung von neuronalen Netzen, welche direkt auf einer Hardware-Plattform ausgeführt werden, kommen heutzutage vermehrt integrierten, elektronischen Schaltungen zum Einsatz. Vor allem sogenannte Field Programmable Gate Arrays oder FPGAs eigenen sich besonders für die Realisierung künstlicher, neuronaler Netze, da von FPGAs aufgrund ihrer Struktur und Flexibilität eine flexible und parallele Umsetzung erlaubt wird.

FPGAs werden durch Definitionen von Funktionsstrukturen und durch Vorgabe von Strukturvorschriften programmiert. Das bedeutet, die Schaltungsstrukturen eines FPGAs können nach der Herstellung durch in das FPGA geladene Daten (z.B. Strukturvorschriften, Schaltpläne, etc.) festgelegt und/oder verändert werden. FPGAs sind daher flexibel einsetzbar und mittels Programmierung können unterschiedliche Schaltungen und Funktionen realisiert bzw. implementiert werden.

Für eine Implementierung eines neuronalen Netzes mittels einer integrierten, elektronischen Schaltung - vor allem mittels FPGA - wird z.B. in einer Designphase ein Entwurf der Neuronen sowie deren Vernetzung und damit einer Struktur für das zu realisierende, neuronale Netz erstellt. Dabei werden beispielsweise die einzelnen Neuronen mit Hilfe einer Hardwarebeschreibungssprache (z.B. HDL, VHDL, Verilog, etc.) nachmodelliert. Mittels Synthese wird dieser Entwurf der jeweiligen Neuronen auf die Ressourcen der integrierten, elektronischen Schaltung abgebildet. D.h. es wird auf Basis einer mittels einer Hardwarebeschreibungssprache erstellten Beschreibung der jeweiligen Neuronen eine sogenannte Netzliste erzeugt, durch welche die jeweiligen Neuronen auf verfügbare Ressourcen der integrierten, elektronischen Schaltung bzw. des FPGAs abgebildet werden. Üblicherweise wird für die hardwaremäßige Umsetzung eines neuronalen Netzes bzw. der einzelnen Neuronen eine relativ große Zahl an Ressourcen (wie z.B. Lookup-Tables, digitale Signalprozessoren (DSPs), Gatter, Schieberegister, Speicherblöcke, etc.) benötigt. Implementierungen von künstlichen, neuronalen Netzen mittels FPGAs sind beispielswiese aus den Schriften: Nurviadhi, E. et. al.: Accelerating Binarized Neural Networks: Comparison of FPGA, CPU, GPU and ASIC, 2016, IEEE; oder Haruyoshi Yonekawa und Hiroki Nakahara: On-chip Memory Based Binarized Convolutional Deep Neural Network Applying Batch Normalization Free Technique on an FPGA, 2017, IEEE p. 98-105.

Das Training des neuronalen Netzes mit allen Schichten und dazugehörenden Neuronen kann beispielsweise direkt auf der Hardware-Plattform der integrierten, elektronischen Schaltung bzw. dem FPGA durchgeführt werden. Dazu wird beispielsweise die aus der Synthese erhaltene Netzliste der Neuronen bzw. des neuronalen Netzes auf die Hardware-Plattform bzw. die integrierte, elektronische Schaltung (z.B. FPGA) übertragen. D.h. die Neuronen werden durch die in der Netzliste angegebenen Ressourcen (z.B. Lookup-Tables, digitale Signalprozessoren (DSPs), Gatter, Schieberegister, Speicherblöcke, etc.) nachgebildet. Die entsprechenden, im jeweiligen Trainingszyklus aktuellen Gewichtungen/Gewichtungsfaktoren der künstlichen Neuronen sind dabei z.B. in zugehörigen Speicherblöcken (z.B. Block-RAMs) der integrierten, elektronischen Schaltung bzw. des FPGAs abgelegt. Für jeden neuen Trainingszyklus müssen z.B. die jeweils aktuellen bzw. die aufgrund des vorherigen Trainingsergebnisses adaptierten Gewichtungen direkt in die entsprechenden Speicherblöcke geladen werden, bis für die vorgegebene Aufgabenstellung optimale Gewichtungen bzw. optimale Gewichtungsfaktoren gefunden sind. Diese werden dann für den laufenden Betrieb als Fixwerte in den Speicherblöcken der hardwaremäßigen Umsetzung der jeweiligen Neuronen beibehalten.

Alternativ kann das Training des künstlichen, neuronalen Netzes auch mittels eines Softwaremodells erfolgen, welches beispielsweise auf Basis der Netzliste erstellt und im Prinzip der hardwaremäßigen Realisierung in der integrierten, elektronischen Schaltung ident ist. Mit Hilfe von Trainingsdaten und/oder -mustern werden mit dem Softwaremodell die optimalen Gewichtungen bzw. Gewichtungsfaktoren für die Neuronen - z.B. ausgehend von einer vorgebbaren oder zufälligen Startgewichtung - ermittelt. Nach Ermittlung der optimalen Gewichtungen wird das trainierte, neuronale Netz auf die Hardware-Plattform der integrierten, elektronischen Schaltung übertragen. Die Gewichtungen der jeweiligen Neuronen werden dann z.B. als Fixwerte in den Speicherblöcken der hardwaremäßigen Umsetzung der jeweiligen Neuronen abgelegt.

Bei beiden, beispielhaften Trainingsmethoden für ein in einer integrierten, elektronischen Schaltung implementiertes neuronales Netz sind die Verbindungen der Neuronen üblicherweise fix. Nur die Speicherblöcke, in welchen die Gewichtungen abgelegt sind, können z.B. während der Trainingsphase dynamisch nachgeladen werden. Wird beispielsweise während der Trainingsphase festgestellt, dass eine Veränderung der Verbindung der Neuronen notwendig ist, so kann diese Veränderung nur durch eine neuerliche Synthese erreicht werden. D.h. Änderungen in der Struktur des neuronalen Netzes bzw. in der Verbindung der Neuronen sind mit relativ großem Aufwand verbunden.

Weiterhin führt das Ablegen der Gewichtungen in eigenen Speicherblöcken bei der hardwaremäßigen Umsetzung der jeweiligen Neuronen dazu, dass für eine Berechnung der sogenannten Gewichtsmatrix des jeweiligen Neurons beispielsweise einige Taktzyklen benötigt werden (z.B. Auslesen der gespeicherten Gewichtung, Berechnen der Gewichtsmatrix, etc.). Dies hat insbesondere eine nachteilige Auswirkung auf die Verarbeitungsgeschwindigkeit - sowohl in der Trainingsphase als auch im laufenden Einsatz des neuronalen Netzes.

### Darstellung der Erfindung

Der Erfindung liegt daher die Aufgabe zugrunde, ein Verfahren zur Realisierung eines künstlichen, neuronalen Netzes mittels einer elektronischen, integrierten Schaltung, insbesondere mittels eines Field Programmable Gate Arrays (FPGA), anzugeben, durch welches ohne großen Aufwand ein geringerer Ressourcenverbrauch sowie eine höhere Verarbeitungsgeschwindigkeit erzielt wird und eine flexiblere Handhabung während der Trainingsphase ermöglicht wird.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs angeführten Art zur Realisierung eines künstlichen, neuronalen Netzes mittels einer integrierten, elektronischen Schaltung, insbesondere mittels eines Field Programmable Gate Arrays oder FPGAs, wobei das Verfahren folgende Schritte umfasst. Zuerst wird eine funktionale Beschreibung unter Einbeziehung einer vorgebbaren Startgewichtung für jedes Neuron des künstlichen, neuronalen Netzes erstellt. Dann wird eine Synthese auf Basis der jeweiligen funktionalen Beschreibung mit der jeweils zugehörigen, vorgebbaren Startgewichtung für das jeweilige Neuron durchgeführt. Als Syntheseergebnis wird eine Netzliste erstellt, in welcher für jedes Neuron zumindest ein Basiselement sowie eine zum zumindest einen Basiselement gehörende Ausgangskonfiguration hinterlegt wird. Das Basiselement wird dabei von einer sogenannten Lookup-Table- oder LUT-Einheit und einer zugeordneten, dynamischen Konfigurationszelle der integrierten, elektronischen Schaltung gebildet, wobei in der Konfigurationszelle eine jeweils aktuelle Konfiguration für die zugehörige LUT-Einheit abgelegt wird. Dann wird die Netzliste als Startkonfiguration des künstlichen, neuronalen Netzes in die elektronische, integrierte Schaltung, insbesondere ins FPGA, geladen und implementiert.

Der Hauptaspekt der gegenständlichen Erfindung besteht darin, dass bereits beim Design bzw. bei der funktionalen Beschreibung eine Startgewichtung für die jeweiligen Neuronen mitberücksichtigt wird. Dabei kann als Startgewichtung beispielsweise ein maximal möglicher Wert für die Gewichtung bzw. Gewichtungsfaktoren des jeweiligen Neurons herangezogen werden. Durch die Abbildung der jeweiligen Neuronen auf zumindest eine Basiseinheit wird weiterhin der Bedarf an Hardware-Ressourcen der elektronischen, integrierten Schaltung je Neuron erheblich reduziert. Insbesondere ist kein zusätzlicher Speicherblock, wie z.B. ein Block-RAM, zum Ablegen der aktuellen Gewichtung des jeweiligen Neurons notwendig. Die Gewichtung ist bereits in der funktionalen Beschreibung des jeweiligen Neurons bzw. in der jeweiligen Konfiguration für die zumindest einen Basiseinheit, auf welche das Neuron abgebildet wird, berücksichtigt bzw. integriert. Die Konfiguration für das jeweilige Basiselement ist dabei in einer dynamischen, zum Basiselement gehörenden Konfigurationszelle abgelegt, welche zum Konfigurationsspeicher der elektronischen, integrierten Schaltung gehört und deren Inhalt beim Hochlaufen der elektronischen, integrierten Schaltung in die LUT-Einheit des Basiselements geladen wird. Eine LUT-Einheit ist dabei in der digitalen Schaltungstechnik bzw. bei elektronischen, integrierten Schaltungen eine Logikeinheit, mit welcher durch Laden einer entsprechenden, zugehörigen Konfiguration, insbesondere in Form einer Logiktabelle, aus der zugehörigen Konfigurationsspeicherzelle beim Hochlaufen der Schaltung eine gewünschte Funktion (z.B. AND, OR, NOR, XOR oder auch komplexere Funktionen) realisiert werden kann.

Weiterhin wird durch den Entfall zusätzlicher Speicherblöcke (wie z.B. Block-RAMs) für die Gewichtungen der Neuronen, welche während des Betriebs des neuronalen Netzwerks ausgelesen werden müssen, und durch den Wegfall einer Berechnung einer Gewichtungsmatrix für das jeweilige Neuron wird außerdem die Verarbeitungsgeschwindigkeit des neuronalen Netzes erhöht.

Eine bevorzugte Ausgestaltung des erfindungsgemäßen Verfahrens sieht vor, dass beim Erstellen der funktionalen Beschreibung unter Einbeziehung der vorgebbaren Startgewichtung des jeweiligen Neurons eine Funktionalität des jeweiligen Neurons derart reduziert wird, dass das jeweilige Neuron auf ein Basiselement abgebildet wird. Auf diese Weise kann der Ressourcenbedarf eines Neurons wesentlich reduziert werden. Die Funktion des Neurons wird dabei idealerweise mit der dazugehörenden Gewichtung als Gesamtfunktion in der LUT-Einheit des Basiselements über die Konfigurationszelle - beim Hochlaufen der elektronischen, integrierten Schaltung bzw. des FPGAs - konfiguriert bzw. abgebildet.

Eine zweckmäßige Weiterbildung des erfindungsgemäßen Verfahrens sieht vor, dass ausgehend von der in der elektronischen, integrierten Schaltung implementierten Startkonfiguration des künstlichen, neuronalen Netzes eine Trainingsphase durchlaufen wird, bei welcher die Startkonfiguration und/oder eine jeweils aktuelle Konfiguration von zumindest einem Basiselement und/oder von zumindest einem Neuron verändert wird. Durch den Einsatz der Basiselemente bestehend aus einer LUT-Einheit und einer zugehörigen, dynamischen Konfigurationszelle können während der Trainingsphase sehr einfach und flexibel Änderungen vorgenommen werden. Eine funktionale Ausgestaltung und/oder eine Gewichtung von zumindest einem Neuron, welche als funktionaler Inhalt in der LUT-Einheit während des Betriebs der elektronischen, integrierten Schaltung abgelegt ist, kann sehr einfach über die Konfigurationszelle variiert werden. Die Konfigurationszelle wird damit während der Trainingsphase des künstlichen, neuronalen Netzes als Trainingsspeicher für das jeweilige Neuron bzw. Basiselemente genutzt. Idealerweise wird die Trainingsphase des künstlichen, neuronalen Netzes direkt auf der Schaltung bzw. im laufenden Betrieb der Schaltung durchgeführt. Ist die optimale Konfiguration des neuronalen Netzes zum Lösen der jeweiligen Aufgabe (z.B. Text-, Bild- oder Mustererkennung, Entscheidungsaufgabe, etc.) gefunden, kann beispielsweise die jeweilige Konfiguration in den Konfigurationszellen der Basiselemente fixiert werden.

Dabei ist es von Vorteil, wenn in der Trainingsphase des künstlichen, neuronalen Netzes fix vorgegebene Testdaten und/oder Testmuster herangezogen werden. Mit den Testdaten und/oder dem Testmuster erzielte Ausgabedaten des künstlichen, neuronalen Netzes werden mit vorgegebenen Referenzdaten verglichen. Eine Veränderung der jeweils aktuellen Konfiguration von zumindest einer Basiseinheit und/oder zumindest einem Neuron wird iterativ durchgeführt, bis die mit den Testdaten und/oder dem Testmuster erzielten Ausgabedaten des künstlichen, neuronalen Netzes den vorgegebenen Referenzdaten bis auf eine vorgebbare Toleranz entsprechen. Während der Trainingsphase kann durch die Veränderung von einem oder mehreren Neuronen eine iterative Annäherung erzielt werden, bis eine optimale Lösung der Aufgabe erreicht worden ist.

Weiterhin wird idealerweise während der Trainingsphase des künstlichen, neuronalen Netzes zum Einspielen einer Veränderung der Startkonfiguration und/oder der jeweils aktuellen Konfiguration des zumindest einen Basiselements und/oder des zumindest einen Neurons eine speziell vorgegebenen Schnittstelle der elektronischen, integrierten Schaltung bzw. des FPGAs genutzt. Veränderungen von einzelnen Neuronen können damit sehr einfach während der Trainingsphase in die entsprechenden Konfigurationszellen der entsprechenden Basiselemente geladen werden. Beim Hochlaufen der elektronischen, integrierten Schaltung werden dann die Veränderungen einzelner Neuronen in die jeweiligen LUT-Einheiten der entsprechenden Basiselemente geladen und es kann die neue bzw. veränderte Konfiguration des künstlichen, neuronalen Netzes sehr rasch getestet werden.

Es ist vorteilhaft, wenn als Konfigurationszelle zum Abspeichern der jeweils aktuellen Konfiguration des jeweiligen Basiselements eine Speichereinheit des Konfigurationsspeichers der elektronischen, integrierten Schaltung verwendet wird. Der Konfigurationsspeicher der elektronischen, integrierten Schaltung, insbesondere des FPGAs, ist üblicherweise eine Speichereinheit, in welcher die jeweils aktuelle Konfiguration abgelegt ist. Diese Konfiguration wird dann beim Hochlaufen der Schaltung bzw. des FPGAs geladen und gibt die aktuelle Funktionalität der Schaltung, Verwendung der Ressourcen sowie die Verknüpfung der jeweils verwendeten Ressourcen vor. Damit werden einerseits Ressourcen gespart und andererseits können Änderungen während der Trainingsphase leicht eingebracht werden.

Es ist günstig, wenn die Konfigurationszelle zum Abspeichern der jeweils aktuellen Konfiguration des jeweiligen Basiselements als sogenannte Static RAM ausgeführt wird. Ein Static RAM ist ein elektronischer, flüchtiger Speicherbaustein, welcher eine in ihm abgelegte Dateninformation behält, solange die Betriebsspannung angelegt ist. Alternativ können die Konfigurationszellen auch als so genannte Flash-Speicher ausgeführt sein, welche einen nichtflüchtige Speicherung bei gleichzeitig niedrigem Energieverbrauch ermöglichen.

Idealerweise wird die funktionale Beschreibung des jeweiligen Neurons des künstlichen, neuronalen Netzes in einer Hardwarebeschreibungssprache, insbesondere in einer sogenannten Hardware Description Language oder HDL, erstellt.

### Kurzbeschreibung der Zeichnung

Die Erfindung wird nachfolgend in beispielhafter Weise anhand der beigefügten Figuren erläutert. Dabei zeigt:
Figur 1a eine beispielshafte und verallgemeinerte Struktur eines künstlichen, neuronalen Netzes;
Figur 1b eine beispielshafte und verallgemeinerte Basisstruktur eines künstlichen Neurons;
Figur 2 eine beispielhafte, schematische Umsetzung eines Neurons mit eigenem Speicherblock für zugehörige Gewichtungsfaktoren während einer Trainingsphase;
Figur 3 einen schematischen Ablauf des erfindungsgemäßen Verfahrens zur Realisierung eines künstlichen, neuronalen Netzes mittels einer integrierten, elektronischen Schaltung; und
Figur 4 eine beispielhafte, schematische Darstellung eines Basiselements für ein Neuron zur Verwendung im erfindungsgemäßen Verfahren

### Ausführung der Erfindung

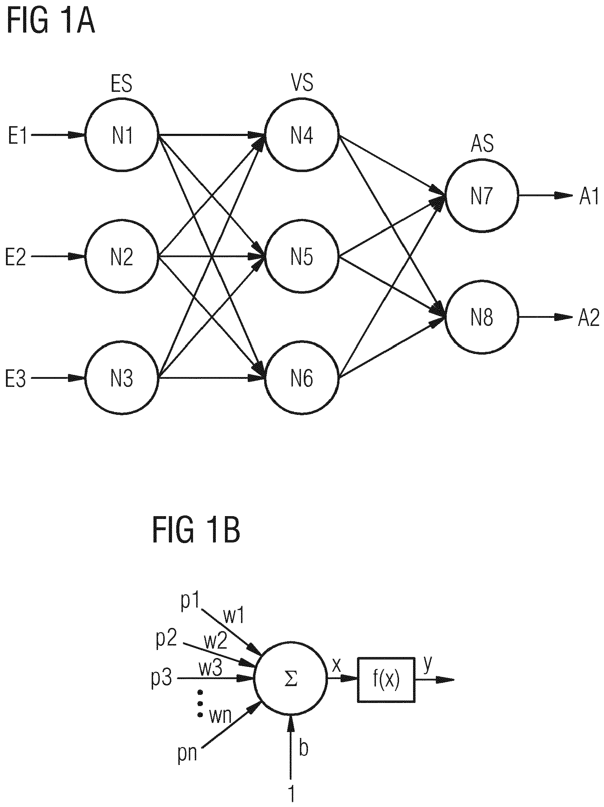

Künstliche neuronale Netze sind natürlichen neuronalen Netzen nachempfunden. Ein künstliches neuronales Netz stellt daher üblicherweise ein stark vereinfachtes Abstraktionsmodell eines natürlichen neuronalen Netzes dar, wobei das künstliche neuronale Netz aus künstlichen Neuronen aufgebaut ist, welche netzartig miteinander verbunden sind. Eine Struktur eines derartigen künstlichen neuronalen Netzes - wie z.B. aus Rey, Günter Daniel; Wender, Karl F.: Neuronale Netze - Eine Einführung in die Grundlagen, Anwendungen und Datenauswertung, 2. Auflage, Huber Verlag, 2010 bekannt - sowie ein beispielhafte Basisstruktur eines künstlichen Neurons - wie z.B. in der Schrift Muthuramalingam, A, et al., Neural Network Implemen-tation Using FPGA: Issues and Application, International Journal of Electrical and Computer Engineering Vol. 2, No. 12, 2008. dargestellt - werden anhand der Figuren 1a und 1b näher beschrieben.

Figur 1a zeigt beispielhaft die Struktur eines mehrschichtiges, sogenannten "Feedforward Neuronal Networks", wobei die Struktur des Netzes beispielsweise unmittelbar mit dem jeweils verwendeten Lern- oder Trainingsverfahren zusammenhängt und ein notwendiger Umfang des neuronalen Netzes von Komplexität der jeweils zu lösenden Aufgabe (z.B. Text-, Bild- oder Mustererkennung, Entscheidungsfindung oder Klassifizierungsaufgabe, etc.) abhängt. Das neuronale Netz besteht aus mehreren Neuronen N1 bis N8, welche dazu eingesetzt werden, Informationen aus der Umwelt oder von anderen Neuronen N1 bis N8 aufzunehmen und an andere Neuronen N1 bis N8 oder die Umwelt in modifizierter Form weiterzuleiten. Dazu sind die Neuronen N1 bis N8 beispielsweise in unterschiedliche Schichten ES, VS, AS gruppiert und miteinander vernetzt. Ein neuronalen Netz kann beispielsweise eine Eingangsschicht ES bestehend aus Eingangsneuronen N1, N2, N3, eine oder mehrere verborgene Schichten VS und eine Ausgangsschicht AS mit Ausgangsneuronen N7, N8 umfassen. Von der Eingangsschicht ES bzw. den Eingangsneuronen N1, N2, N3 werden Signale, Reize oder Muster über Eingänge E1, E2, E3 aufgenommen. Die Ausgänge der Eingangsneuronen N1, N2, N3 sind mit den Neuronen N4, N5, N6 der verborgene Schicht VS verbunden und deren Ausgänge mit den Ausgangsneuronen N7, N8, über deren Ausgänge A1, A2 dann Signale bzw. Ausgabedaten abgegeben werden.

In Figur 1b ist beispielhaft eine verallgemeinerte Basisstruktur eines künstlichen Neurons N1 bis N8 mit n Eingangsverbindungen. Über die Eingangsverbindungen erhält das Neuron seinen Eingabewerte p1, p2, p3, ..., pn z.B. in Form von Signalen, Reizen oder Muster aus der Umwelt oder in Form Ausgangsdaten anderen Neuronen. Diese Eingabewerte p1, p2, p3, ..., pn werden jeweils mit einer Gewichtung bzw. Gewichtsfaktoren w1, w2, w3, ..., wn verknüpft. Die Gewichtung bzw. die Gewichtsfaktoren w1, w2, w3, ..., wn können beispielsweise vor einer Trainingsphase für das neuronale Netz als Startgewichtung w1, w2, w3, ..., wn für das jeweilige Neuron vorgegeben werden, wobei als Startgewichtung z.B. ein maximal möglicher Wert für die Gewichtung bzw. Gewichtungsfaktoren w1, w2, w3, ..., wn des jeweiligen Neurons herangezogen werden. Während der Trainingsphase kann die Gewichtung w1, w2, w3, ..., wn entsprechend variiert werden. Weiterhin kann bei einem künstlichen Neuron ein sogenannter Bias-Eingang b mit einem Eingabewert 1 vorgesehen sein.

Die Funktionalität des Neurons, welche zur Erstellung der funktionalen Beschreibung für eine Realisierung mittels einer integrierten, elektronischen Schaltung herangezogen werden kann, wird im Prinzip durch eine Übertragungsfunktion Σ und einen Aktivierungsfunktion f(x) beschrieben. Mittels der Übertragungsfunktion Σ wird anhand der Gewichtung w1, w2, w3, ..., wn der Eingabewerte p1, p2, p3, ..., pn gegebenenfalls unter Berücksichtigung des Eingabewerts des Bias-Eingangs b eine Netzeingabe x des Neurons berechnet. Die Ausgabe y des Neurons wird durch die Aktivierungsfunktion f(x) bestimmt, wobei für die Aktivierungsfunktion verschiedenen Funktionstypen in Abhängigkeit von der jeweiligen Netztopologie verwendet werden können. Als Aktivierungsfunktion f(x) kann beispielsweise eine lineare Funktion, eine sigmoide Funktion, eine stückweise lineare Funktion oder eine Sprungfunktion verwendet werden.

Für die Umsetzung der Funktionalität eines einzelnen Neurons, wie z.B. in Figur 1b dargestellt, müssen die Übertragungsfunktion Σ sowie die Aktivierungsfunktion f(x) berechnet werden. Dazu können beispielsweise unterschiedliche Berechnungseinheiten (z.B. Addierer, Multiplizierer, komplexe Auswerteeinheiten, etc.) verwendet werden, welche bei einer Realisierung mittels einer elektronischen, integrierten Schaltung (z.B. FPGA) durch unterschiedliche Schaltungsblöcke hardwaremäßig umgesetzt werden. Derzeit bekannte Umsetzungen von künstlichen Neuronen bzw. neuronalen Netzen mittels elektronischer, integrierter Schaltungen, insbesondere mittels eines FPGAs, sind aus den Schriften: Muthuramalingam, A, et al., Neural Network Implemen-tation Using FPGA: Issues and Application, International Journal of Electrical and Computer Engineering Vol. 2, No. 12, 2008; Nurviadhi, E. et. al.: Accelerating Binarized Neural Networks: Comparison of FPGA, CPU, GPU and ASIC, 2016, IEEE; oder Haruyoshi Yonekawa und Hiroki Nakahara: On-chip Memory Based Binarized Convolutional Deep Neural Network Applying Batch Normalization Free Technique on an FPGA, 2017, IEEE p. 98-105; bekannt.

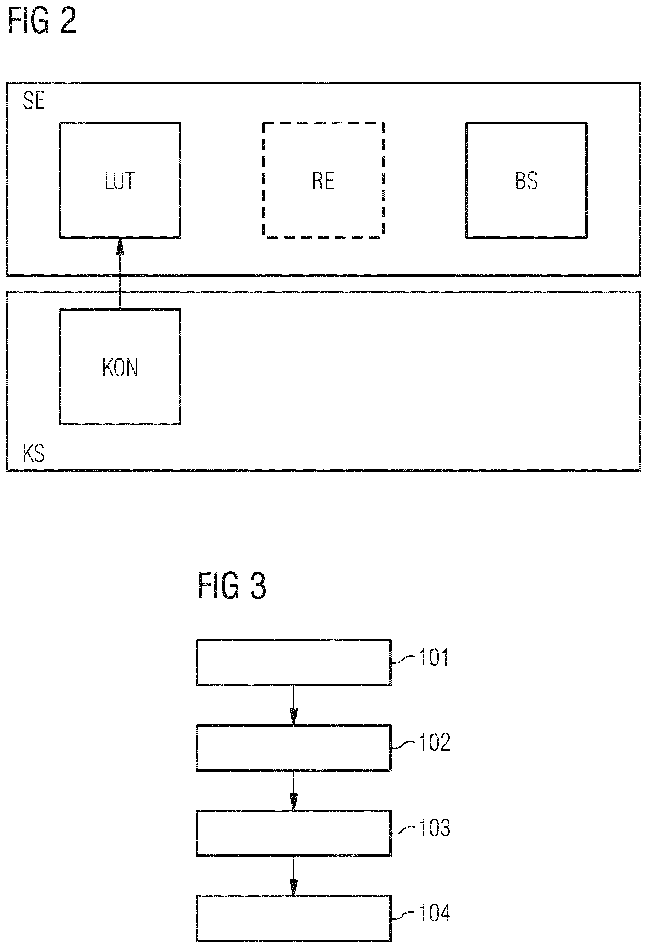

Ein heutzutage auf einer elektronischen, integrierten Schaltung SE bzw. auf einem FPGA realisiertes, künstliches Neurons kann - wie in Figur 2 vereinfacht und beispielhaft dargestellt - z.B. zumindest aus einer Lookup-Table- bzw. LUT-Einheit LUT und einen Speicherblock BS bestehen. Optional kann auch eine Berechnungseinheit RE vorgesehen sein. Für Konfiguration der LUT-Einheit LUT bzw. die Realisierung der Funktion der LUT-Einheit LUT wird beispielsweise eine zur LUT-Einheit LUT gehörende Konfigurationszelle KON im Konfigurationsspeicher KS der elektronischen, integrierten Schaltung SE eingesetzt. Bei Neuronen mit komplexer Funktionalität können diese Einheiten LUT, RE und BS sowie zur den LUT-Einheiten LUT zugeordneten Konfigurationszellen KON gegebenenfalls mehrfach vorgesehen sein.

Mittels der LUT-Einheit LUT und der gegebenenfalls vorhandenen Berechnungseinheit RE werden z.B. in der Trainingsphase und im laufenden Betrieb die Übertragungsfunktion Σ und die Aktivierungsfunktion f(x) realisiert. Die Funktion der LUT-Einheit ist dazu beispielsweise fix durch die in der zugehörigen Konfigurationszelle KON gespeicherte Konfiguration der LUT-Einheit vorgegeben. Die Berechnungseinheit RE kann beispielsweise als digitaler Signalprozessor (DSP) realisiert oder aus z.B. Gatter, Schieberegister, Addier- und/oder Multipliziereinheiten aufgebaut sein. Die Gewichtung w1, w2, w3, ..., wn für die Berechnung der Netzeingabe des Neurons mittels der Übertragungsfunktion Σ wird von zumindest einem Blockspeicher BS zur Verfügung gestellt, welcher z.B. als sogenanntes Block-RAM oder BRAM ausgeführt sein kann. Der Inhalt des zumindest einen Blockspeichers BS -d.h. die jeweilige Gewichtung w1, w2, w3, ..., wn des jeweiligen Neurons - kann beispielsweise während der Trainingsphase verändert werden. D.h. zum Trainieren der Neuronen bzw. des neuronalen Netzes wird die Gewichtung w1, w2, w3, ..., wn von zumindest einem Neuron modifiziert, welche in einem eigenen Speicherblock BS abgelegt ist. Wird während der Trainingsphase ein Ausgabeergebnis mit gewünschter Qualität vom neuronalen Netz erzielt, so werden die in den jeweiligen Speicherblöcken BS abgelegten Gewichtungen w1, w2, w3, ..., wn fixiert.

Figur 3 zeigt einen beispielhaften und schematischen Ablauf des erfindungsgemäßen Verfahrens zum Realisieren eines künstlichen, neuronalen Netzes mittels einer elektronischen, integrierten Schaltung SE, welche beispielsweise als FPGA ausgestaltet ist. Das künstliche, neuronale Netz besteht dabei aus Neuronen - wie beispielhaft in Figur 1b dargestellt, welche wie anhand von Figur 1a beispielhaft beschrieben in Schichten gruppiert und miteinander vernetzt sind. In einem ersten Verfahrensschritt 101 des erfindungsgemäßen Verfahrens wird für jedes Neuron einen funktionale Beschreibung erstellt, wobei bereits eine vorgebbare Startgewichtung für das jeweilige Neuron in die funktionale Beschreibung einbezogen wird. Die Startgewichtung kann beispielsweise zufällig gewählt sein oder es werden maximal möglich Werte für die Gewichtung w1, w2, w3, ..., wn als Startgewichtung herangezogen. Die funktionale Beschreibung des jeweiligen Neurons wird beispielsweise in einer Hardwarebeschreibungssprache - in einer sogenannten Hardware Description Language (z.B. HDL, VHDL, Verilog, etc.) - abgefasst.

In einem zweiten Verfahrensschritt 102 wird auf Basis der jeweiligen funktionalen Beschreibung des jeweiligen Neurons, bei welcher die jeweils zugehörige Startgewichtung vorgegeben ist bzw. einbezogen wurde, eine Synthese durchgeführt und im dritten Verfahrensschritt 103 eine Netzliste als Syntheseergebnis erstellt bzw. erhalten. D.h. es wird die funktionalen Beschreibung der Neuronen bzw. des neuronalen Netzes, welche meist in einer Hardwarebeschreibungssprache vorliegt, in eine Netzliste umgewandelt. Die Netzliste umfasst üblicherweise eine Beschreibung der für die Schaltungsrealisierung notwendigen Module (z.B. Logikgatter, Speicherblöcke, etc.) und der entsprechenden Verbindungen zwischen den Modulen. In der im dritten Verfahrensschritt 103 erstellten Netzliste sind dabei für jedes Neuron zumindest ein Basiselement BEI sowie einen zum Basiselement BEI gehörende Startkonfiguration hinterlegt.

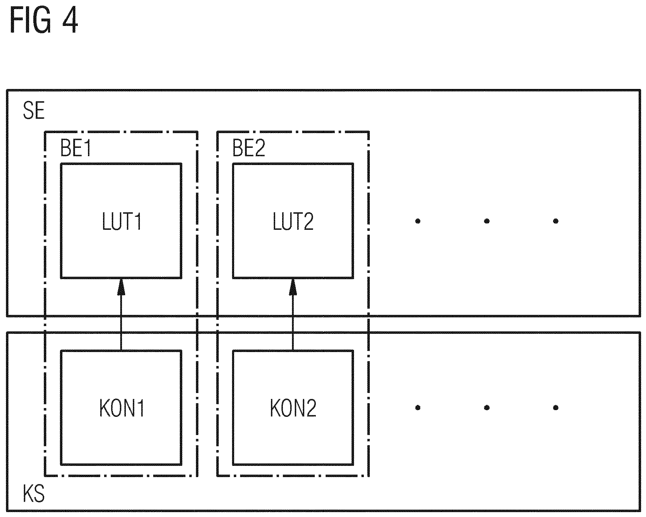

Ein derartiges Basiselement BEI ist beispielhaft und schematisch in Figur 4 dargestellt. Ein Neuron eines nach dem erfindungsgemäßen Verfahren realisierten neuronalen Netzes besteht zumindest aus einem derartigen Basiselement BE1. Funktional komplexere Neuronen können allerdings auch mehrere Basiselemente BE1, BE2, ... aufweisen. Idealerweise wird aber im ersten Verfahrensschritt 101 die Funktionalität des jeweiligen Neurons beim Erstellen der funktionalen Beschreibung unter Einbeziehung der jeweiligen Startgewichtung derart reduziert, dass das jeweilige Neuron auf genau ein Basiselement BEI abgebildet werden kann.

Ein derartiges Basiselement BE1, durch welches ein Neuron gebildet werden kann, wird aus einer LUT-Einheit LUT1 auf der elektronischen, integrierten Schaltung SE und einer zugeordneten, dynamischen Konfigurationszelle KON1 gebildet. In der dynamischen Konfigurationszelle KON1 ist eine jeweils aktuelle Konfiguration für die LUT-Einheit LUT1 abgelegt. Durch diese Konfiguration wird die Funktion der LUT-Einheit LUT1 bestimmt, von welcher im Prinzip die Übertragungsfunktion Σ unter Einbeziehung einer Gewichtung w1, w2, w3, ..., wn und die Aktivierungsfunktion f(x) umgesetzt werden. Als Konfigurationszelle KON1, welche beispielsweise als sogenanntes Static RAM oder als sogenannter Flash-Speicher ausgeführt sein kann, wird z.B. eine Speichereinheit des Konfigurationsspeichers KS der elektronischen, integrierten Schaltung SE genutzt.

Bei einem funktional komplexeren Neuron kann beispielsweise eine weitere Basiseinheit BE2 vorgesehen sein, welche ebenfalls aus einer weiteren LUT-Einheit LUT2 und einer weiteren zugehörigen, dynamischen Konfigurationszelle KON2 besteht, in welcher die jeweils aktuelle Konfiguration für die weitere LUT-Einheit LUT2 abgelegt ist. Werden die Neuronen des neuronalen Netzes im Verfahrensschritt 101 mittels funktionaler Beschreibung derart designt, dass jedes Neuron nur auf eine Basiseinheit BE1, BE2, ... abgebildet wird, so kann die weitere Basiseinheit BE2 bereits ein weiteres Neuron des neuronalen Netzes darstellen.

In einem vierten Verfahrensschritt 104 wird die Netzliste als Startkonfiguration des neuronalen Netzes in die elektronische, integrierte Schaltung SE bzw. ins FPGA SE geladen und implementiert. In der Folge kann dann mit einer Trainingsphase - idealerweise im Online-Betrieb bzw. direkt auf der Schaltung SE - begonnen werden.

Dazu werden z.B. beim Hochfahren bzw. Starten der Schaltung SE bzw. des FPGAs die in den Konfigurationszellen KON1, KON2, ... abgelegten Startkonfigurationen in die LUT-Einheiten LUT1, LUT2, ... geladen. In der Trainingsphase werden fix vorgegebenen Testdaten und/oder Testmuster verwendet, um die vom neuronalen Netz zu lösenden Aufgabe (z.B. Text-, Bild- oder Mustererkennung, Entscheidungsfindung oder Klassifizierungsaufgabe, etc.) durchzuführen. Die mit den Testdaten und/oder Testmustern erzielten Ausgabedaten des neuronalen Netzes werden dann mit vorgegebenen Referenzdaten verglichen und geprüft, ob die erzielten Ausgabedaten bis auf eine vorgebbare Toleranz den Referenzdaten entsprechen.

Wird die vorgebbare Toleranz überschritten bzw. die gewünschte Übereinstimmung mit den Referenzdaten nicht erreicht, so wird ausgehend von der Startkonfiguration bei zumindest einem Basiselement BE1, BE2, ... und/oder bei zumindest einem Neuron die jeweils aktuelle Konfiguration modifiziert. D.h. es wird die in der jeweiligen Konfigurationszelle KON1, KON2, ... gespeicherte Konfiguration der jeweils zugehörigen LUT-Einheit LUT1, LUT2, ... verändert. Dabei kann beispielsweise für das jeweilige Neuron nur die funktionale Beschreibung oder nur die in der funktionalen Beschreibung einbezogene Gewichtung w1, w2, w3, ..., wn oder beides modifiziert werden. Die modifizierte Konfiguration für die jeweilige LUT-Einheit LUT1, LUT2, ... kann beispielsweise über eine speziell vorgegebene Schnittstelle der elektronischen, integrierten Schaltung SE bzw. des FPGAs SE (z.B. spezielle Schnittstelle eines Herstellers der Schaltung bzw. des FPGAs) eingespielt werden.

Wird die vorgebbare Toleranz erreicht/unterschritten bzw. die gewünschte Übereinstimmung zwischen Ausgabedaten des neuronalen Netzes und den Referenzdaten erzielt, dann werden die jeweils aktuellen Konfigurationen der LUT-Einheiten LUT1, LUT2, ... in den zugehörigen Konfigurationszellen KON1, KON2, ... fixiert und die Trainingsphase beendet.

Bei einem durch das erfindungsgemäße Verfahren realisierten neuronalen Netz werden die jeweiligen Neuronen durch zumindest ein jeweiliges Basiselement BE1, BE2 realisiert, wobei die Funktion des jeweiligen Neurons durch die jeweilige LUT-Einheit LUT1, LUT2, ... bestimmt wird. Der funktionale Inhalt der jeweiligen LUT-Einheit LUT1, LUT2, ... kann idealerweise über die zugehörige Konfigurationszelle KON1, KON2, ... variiert werden. Die jeweilige Gewichtung w1, w2, w3, ..., wn des jeweiligen Neurons ist indirekt in der Funktion der jeweiligen LUT-Einheit LUT1, LUT2, ... abgebildet. Dadurch kann ein Verbrauch an Ressourcen der elektronischen, integrierten Schaltung bzw. des FPGAs SE erheblich reduziert und die Verarbeitungsgeschwindigkeit - insbesondere während der Trainingsphase - gesteigert werden.

## Patentansprüche

1. Verfahren zur Realisierung eines künstlichen, neuronalen Netzes mittels einer elektronischen, integrierten Schaltung (SE), insbesondere einem sogenannten Field Programmable Gate Array oder FPGA, wobei das künstliche, neuronale Netz aus künstlichen Neuronen aufgebaut wird, welche in unterschiedlichen Schichten (ES, VS, AS) gruppiert und miteinander vernetzt werden, mit folgenden Schritten:
a. Erstellen einer funktionalen Beschreibung unter Einbeziehung einer vorgebbaren Startgewichtung für jedes Neuron (101);
b. Durchführen einer Synthese auf Basis der jeweiligen funktionalen Beschreibung mit der jeweils zugehörigen, vorgebbaren Startgewichtung für das jeweilige Neuron (102);
c. Erstellen einer Netzliste als Syntheseergebnis, in welcher für jedes Neuron zumindest ein Basiselement (BE1, BE2) sowie eine zum Basiselement (BE1, BE2) gehörende Startkonfiguration hinterlegt wird, wobei das Basiselement (BE1, BE2) von einer sogenannten Lookup-Table- bzw. LUT-Einheit (LUT1, LUT2) und einer zugeordneten, dynamischen Konfigurationszelle (KON1, KON2) gebildet wird, in welcher eine jeweils aktuelle Konfiguration für die zugehörige LUT-Einheit (LUT1, LUT2) abgelegt wird (103);
d. Implementieren der Netzliste als Startkonfiguration des neuronalen Netzes in der elektronischen, integrierten Schaltung (SE) (104).

2. Verfahren nach Anspruch 1, ***dadurch gekennzeichnet, dass*** beim Erstellen der funktionalen Beschreibung unter Einbeziehung der vorgebbaren Startgewichtung des jeweiligen Neurons die Funktionalität des jeweiligen Neurons derart reduziert wird, dass das jeweilige Neuron auf ein Basiselement (BE1, BE2) abgebildet wird.

3. Verfahren nach einem der Ansprüche 1 bis 2, ***dadurch gekennzeichnet, dass*** ausgehend von der in der elektronischen, integrierten Schaltung implementierten Startkonfiguration des künstlichen, neuronalen Netzes eine Trainingsphase durchlaufen wird, bei welcher die Startkonfiguration und/oder eine jeweils aktuelle Konfiguration von zumindest einem Basiselement (BE1, BE2) und/oder von zumindest einem Neuron verändert wird.

4. Verfahren nach Anspruch 3, ***dadurch gekennzeichnet, dass*** in der Trainingsphase des künstlichen, neuronalen Netzes fix vorgegebene Testdaten und/oder Testmuster herangezogen werden, dass mit den Testdaten und/oder dem Testmuster erzielte Ausgabedaten mit vorgegebenen Referenzdaten verglichen werden, und dass eine Veränderung der jeweils aktuellen Konfiguration von zumindest einer Basiseinheit (BE1, BE2) und/oder von zumindest einem Neuron iterativ durchgeführt wird, bis die mit den Testdaten und/oder dem vorgegebenen Testmuster erzielten Ausgabedaten den vorgegebenen Referenzdaten bis auf eine vorgebbare Toleranz entsprechen.

5. Verfahren nach einem der Ansprüche 3 bis 4, ***dadurch gekennzeichnet, dass*** während der Trainingsphase des künstlichen, neuronalen Netzes zum Einspielen einer Veränderung der Startkonfiguration und/oder der jeweils aktuellen Konfiguration des zumindest einen Basiselements (BE1, BE2) und/oder Neurons eine speziell vorgegebene Schnittstelle der elektronischen, integrierten Schaltung (SE) genutzt wird.

6. Verfahren nach einem der vorangegangenen Ansprüche, ***dadurch gekennzeichnet, dass*** als Konfigurationszelle (KON1, KON2) zum Abspeichern der jeweils aktuellen Konfiguration des jeweiligen Basiselements eine Speichereinheit eines Konfigurationsspeichers der elektronischen, integrierten Schaltung (SE) verwendet wird.

7. Verfahren nach einem der vorangegangenen Ansprüche, ***dadurch gekennzeichnet, dass*** die Konfigurationszelle (KON1, KOn2) zum Abspeichern der jeweils aktuellen Konfiguration des jeweiligen Basiselements sogenanntes Static RAM ausgeführt wird.

8. Verfahren nach einem der vorangegangenen Ansprüche, ***dadurch gekennzeichnet, dass*** die funktionale Beschreibung des jeweiligen Neurons in einer Hardwarebeschreibungssprache, insbesondere einer sogenannten Hardware Description Language oder HDL, erstellt wird (101).
